# EUROPÄISCHE PATENTSCHRIFT

(11) **EP 1 497 695 B1**
(45) Veröffentlichungstag und Bekanntmachung des Hinweises auf die Patenterteilung: **02.12.2009**
(21) Anmeldenummer: 03722426.8
(22) Anmeldetag: 09.04.2003
(51) Int. Cl.: G03F 7/00

(54) **NANOIMPRINT-RESIST**
NANOIMPRINT RESIST
COUCHE DE RESERVE DE NANOIMPRESSION

(30) Priorität: 17.04.2002 DE 10217151
(43) Veröffentlichungstag der Anmeldung: 19.01.2005
(73) Patentinhaber: AZ Electronic Materials (Germany) GmbH, 65203 Wiesbaden (DE)
(72) Erfinder: SPIESS, Walter, 64839 Münster (DE); KITA, Fumio, 65187 Wiesbaden (DE); MEIER, Michael, 65835 Liederbach (DE); GIER, Andreas, 49326 Melle (DE); MENNIG, Martin, 66287 Quierschied (DE); OLIVEIRA, Peter, W., 66111 Saarbrücken (DE); SCHMIDT, Helmut, 66130 Saarbrücken-Güdingen (DE)
(74) Vertreter: Isenbruck, Günter
(86) Internationale Anmeldenummer: PCT/EP2003/003666
(87) Internationale Veröffentlichungsnummer: WO 2003/087935

(56) Entgegenhaltungen:
- WO-A-97/33737
- DE-A- 10 001 135
- US-A- 5 817 242

## Beschreibung

Die vorliegende Erfindung liegt auf dem Gebiet der Mikrolithographie.
Die Miniaturisierung elektronischer Bauteile, für die eine Auflösung bis in den Bereich von weniger als 1 µm erforderlich ist, wurde im wesentlichen durch photolithographische Techniken erzielt. Die Grenze der Auflösung ist dabei durch die Wellenlänge der zur Abbildung der Vorlage verwendeten Strahlung vorgegeben, so dass kurzwellige Strahlung, wie energiereiche UV-, Elektronen- und Röntgenstrahlung, eingesetzt werden muss.

Durch das Auftreten von Beugungseffekten bei immer kleiner werdenden Strukturen erreicht die Strukturierung durch Photolithographie ihre physikalischen Grenzen, die bei etwa 150 nm liegen. Andererseits verursachen die immer höheren Anforderungen an Auflösung, Kantensteilheit und Aspektverhältnis (Verhältnis von Höhe zu Auflösung) eine Kostenexplosion bei den zur photolithographischen Strukturierung benötigten Apparaturen, wie Masken, Maskaligner, Stepper.
Insbesondere stellen moderne Stepper durch ihren Preis von mehreren Millionen US$ einen gewaltigen Kostenfaktor in der Mikrochip-Produktion dar.

Der vorliegenden Erfindung lag daher die Aufgabe zugrunde, eine Methode zur Mikrostrukturierung elektronischer Bauteile zu entwickeln, die hohe Auflösungen (≤200 nm) bei gutem Aspektverhältnis liefert, aber deutlich kostengünstiger ist als photolithographische Verfahren.

In der US 5,772,905 wird ein Nanoimprint-Verfahren beschrieben, welches auf einer thermoplastischen Verformung des auf einem Substrat ganzflächig aufgebrachten Resists durch ein auf einem starren Stempel befindliches Relief beruht. Als Resist zum Heißprägen werden Thermoplaste (Polymethylmethacrylat, PMMA) eingesetzt. Aufgrund üblicher Dickenschwankungen von ca. 100 nm über die gesamte Waferoberfläche ist es nicht möglich, 6-, 8- und 12-zöllige Wafer in einem Schritt mit einem starren Stempel zu strukturieren. Somit müsste ein aufwändiges "step and repeat"-Verfahren verwendet werden, was jedoch aufgrund der Wiedererwärmung bereits strukturierter Nachbarbereiche ausscheidet.

In der WO 99/22 849 wird ein Verfahren zur Mikrostrukturierung offenbart, welches einen anderen Weg beschreitet. Dabei wird ein flexibler Stempel aus Polydimethylsiloxan mit der gewünschten Mikrostruktur auf einem flachen, anorganischen Substrat aufgesetzt. Durch die Kapillarkräfte wird anschließend eine Flüssigkeit in die Struktur eingezogen. Dabei handelt es sich um eine wässrige TEOS-Lösung. Das Lösemittel wird durch Osmose entfernt und eine poröse SiO₂-Struktur bleibt zurück. Eingesetzt werden diese Schichten vorwiegend in der Biomimetik (Komposite für Zähne und Knochen).

In der US 5,900,160, der US 5,925,259 und US 5,817,242 wird ein Stempel mit einem UV-härtbaren Resist (self assembled Monolayer, z.B. Alkylsiloxan) benetzt und sodann auf ein glattes Substrat gepresst. Analog zu einem konventionellen Stempelvorgang verbleibt das strukturierte Resist-Material beim Abheben des Stempels auf der Substratoberfläche. Die dabei verwendeten Resistmaterialien zeigen eine ausreichende Benetzung zum Substrat, eignen sich jedoch nicht für ein Lift-off-Verfahren, noch zeigen sie eine ausreichende Ätzresistenz. Die Strukturdimensionen liegen im Bereich von 1 µm und sind damit um mehr als 1 Größenordnung zu groß.

Diese Verfahren sind allesamt ungeeignet, die erfindungsgemäße Aufgabe zu lösen.

Es wurde gefunden, dass die oben genannten Anforderungen durch ein mechanisches Transfer-Prägeverfahren erfüllt werden können, wenn eine bestimmte Nanokomposit-Zusammensetzung als Transfer-Resist (Nanoimprint-Resist) verwendet wird.

Gegenstand der vorliegenden Erfindung ist die Verwendung einer Nanokomposit-Zusammensetzung, enthaltend
a) ein polymerisierbares Silan der allgemeinen Formel (I) und/oder (II) und/oder davon abgeleitete Kondensate

   SiX₄ (I)

   in der die Reste X gleich oder verschieden sind und hydrolysierbare Gruppen oder Hydroxylgruppen bedeuten;

   R¹ₐR²_{b}SiX_{(4-a-b)} (II)

   worin R¹ ein nicht hydrolysierbarer Rest ist, R² einen eine funktionelle Gruppe tragenden Rest bedeutet, X die vorstehende Bedeutung hat und a und b den Wert 0, 1, 2 oder 3 aufweisen, wobei die Summe (a + b) den Wert 1, 2 oder 3 aufweist, sowie
b) nanoskalige Teilchen aus der Gruppe der Oxide, Sulfide, Selenide, Telluride, Halogenide, Carbide, Arsenide, Antimonide, Nitride, Phosphide, Carbonate, Carboxylate, Phosphate, Sulfate, Silikate, Titanate, Zirkonate, Aluminate, Stannate, Plumbate sowie Mischoxide davon, als Resist zur Mikrostrukturierung von Halbleitermaterialien, Flachbildschirmen, mikromechanischen Bauteilen und Sensoren.

In den obigen Formeln sind die hydrolysierbaren Gruppen X beispielsweise Wasserstoff oder Halogen, wie F, Cl, Br oder I; Alkoxy, vorzugsweise C₁₋₆-Alkoxy, wie z.B. Methoxy, Ethoxy, n-Propoxy, i-Propoxy und Butoxy; Aryloxy, vorzugsweise C₆₋₁₀-Aryloxy, wie z.B. Phenoxy; Acyloxy, wie z.B. Acetoxy oder Propionyloxy; Alkylcarbonyl, vorzugsweise C₂₋₇-Alkylcarbonyl, wie z.B. Acetyl; Amino, Monoalkylamino oder Dialkylamino mit vorzugsweise 1 bis 12, insbesondere 1 bis 6 Kohlenstoffatomen in der bzw. den Alkylgruppe(n).

Der nicht hydrolysierbare Rest R¹ ist beispielsweise Alkyl, vorzugsweise C₁₋₆-Alkyl, wie z.B. Methyl, Ethyl, n-Propyl, Isopropyl, n-Butyl, i-Butyl und t-Butyl, Pentyl, Hexyl oder Cyclohexyl; Alkenyl, vorzugsweise C₂₋₆-Alkenyl, wie z.B. Vinyl, 1-Propenyl, 2-Propenyl und Butenyl; Alkinyl, vorzugsweise C₂₋₆-Alkinyl, wie z.B. Acetylenyl und Propargyl; und Aryl, vorzugsweise C₆₋₁₀-Aryl, wie z.B. Phenyl und Naphthyl.
Die genannten Reste R¹ und X können gegebenenfalls einen oder mehrere übliche Substituenten, wie z.B. Halogen oder Alkoxy, aufweisen.

Konkrete Beispiele für die funktionellen Gruppen des Restes R² sind Epoxy-, Hydroxy-, Ether-, Amino- , Monoalkylamino-, Dialkylamino-, Amid-, Carboxy-, Mercapto-, Thioether-, Vinyl-, Acryloxy-, Methacryloxy-, Cyano-, Halogen-, Aldehyd-, Alkylcarbonyl-, Sulfonsäure- und Phosphorsäuregruppen. Diese funktionellen Gruppen sind vorzugsweise über Alkylen-, Alkenylen- oder Arylen-Brückengruppen, die durch Sauerstoff- oder Schwefelatome oder -NH-Gruppen unterbrochen sein können, an das Siliciumatom gebunden. Die genannten Brückengruppen leiten sich zum Beispiel von den oben genannten Alkyl-, Alkenyl- oder Arylresten ab. Die Brückengruppen der Reste R² enthalten vorzugsweise 1 bis 18, insbesondere 1 bis 8 Kohlenstoffatome.

In der allgemeinen Formel (II) hat a vorzugsweise den Wert 0, 1 oder 2, b hat vorzugsweise den Wert 1 oder 2 und die Summe (a + b) weist vorzugsweise den Wert 1 oder 2 auf.

Besonders bevorzugte hydrolysierbare Silane der allgemeinen Formel (I) sind Tetraalkoxysilane wie Tetraethoxysilan (TEOS) und Tetramethoxysilan. Besonders bevorzugte Organosilane der allgemeinen Formel (II) sind Epoxysilane, wie 3-Glycidyloxy-propyltrimethoxysilan (GPTS) oder 3-Glycidyloxypropyltriethoxysilan, und über reaktive polymerisierbare Doppelbindungen verfügende Silane wie beispielsweise Acryloxypropyltrimethoxysilan oder 3-Methacryloxy-propyltrimethoxysilan. Die genannten Silane bzw. deren funktionelle Gruppen sind deshalb bevorzugt, weil sie (nach erfolgter hydrolytischer Polykondensation) zu einer Polyadditions- bzw. Polymerisationsreaktion mit zum Beispiel den polymerisierbaren mono- und/oder bifunktionellen organischen Monomeren, Oligomeren und/oder Polymeren herangezogen werden können und/oder mit an der Oberfläche der nanoskaligen Teilchen befindlichen reaktiven Gruppen reagieren und somit zur Immobilisierung (z.B. durch Einbindung in ein Netzwerk) der nanoskaligen Teilchen beitragen können.

Die Hydrolyse und Polykondensation der obigen Verbindungen wird auf herkömmliche Art und Weise durchgeführt, gegebenenfalls in Gegenwart eines sauren oder basischen Kondensationskatalysators wie HCl, HNO₃ oder NH₃. So können Hydrolyse und Polykondensation beispielsweise unter den (allgemein bekannten) Bedingungen des Sol-Gel-Prozesses erfolgen.

Der Volumenanteil der nanoskaligen Teilchen in der Nanokomposit-Zusammensetzung beträgt zweckmäßigerweise 1 bis 50 Vol.-%, vorzugsweise 1 bis 30 Vol.-% und insbesondere 5 bis 20 Vol.-%.
Die nanoskaligen Partikel haben gewöhnlich eine Teilchengröße von 1 bis 200 nm, vorzugsweise 2 bis 50 nm und insbesondere 5 bis 20 nm.
Nanoskalige anorganische Teilchen als solche sind bekannt, z.B. aus der WO 96/31572, und sind beispielsweise Oxide wie CaO, ZnO, CdO, SiO₂, TiO₂, ZrO₂, CeO₂, SnO₂, PbO, Al₂O₃, In₂O₃ und La₂O₃; Sulfide wie CdS und ZnS; Selenide wie GaSe, CdSe oder ZnSe; Telluride wie ZnTe oder CdTe; Halogenide wie NaCl, KCl, BaCl₂, AgCl, AgBr, Agl, CuCl, CUBr, Cdl₂ oder Pbl₂; Carbide wie CeC₂; Arsenide wie AlAs, GaAs oder CeAs; Antimonide wie InSb; Nitride wie BN, AIN, Si₃N₄ oder Ti₃N₄; Phosphide wie GaP, InP, Zn₃P₂ oder Cd₃P₂; Carbonate wie Na₂CO₃, K₂CO₃, CaCO₃, SrCO₃ und BaCO₃; Carboxylate, z.B. Acetate wie CH₃COONa und Pb(CH₃COO)₄; Phosphate; Sulfate; Silicate; Titanate; Zirkonate; Aluminate; Stannate; Plumbate und entsprechende Mischoxide, deren Zusammensetzung vorzugsweise der Zusammensetzung herkömmlicher Gläser mit niedrigem thermischen Ausdehnungskoeffizienten entspricht, z.B. binäre, tertiäre oder quaternäre Kombinationen von SiO₂, TiO₂, ZrO₂ und Al₂O₃. Ebenfalls geeignet sind z.B. Mischoxide mit Perowskit-Struktur wie BaTiO₃ oder PbTiO₃. Außerdem können organisch modifizierte anorganische Teilchen wie z.B. partikuläre Polymethylsiloxane, methacrylfunktionalisierte Oxidpartikel und Salze der Methylphosphorsäure verwendet werden.

Die Herstellung dieser nanoskaligen Partikel kann auf übliche Weise erfolgen, z.B. durch Flammhydrolyse, Flammpyrolyse und Plasmaverfahren gemäß der in der WO 96/31 572 genannten Literatur. Besonders bevorzugt sind stabilisierte kolloidale, nanodisperse Sole von anorganischen Teilchen wie z.B. Kieselsole der Fa. BAYER, SnO₂-Sole der Fa. Goldschmidt, TiO₂-Sole der Fa. MERCK, SiO₂-, ZrO₂-, Al₂O₃-, Sb₂O₃-Sole der Fa. Nissan Chemicals oder Aerosildispersionen der Fa. DEGUSSA.

Die nanoskaligen Teilchen können durch Oberflächenmödifizierung in ihrem Viskositätsverhalten verändert werden.
Als Oberflächenmodifikator, d.h. als oberflächenmodifizierende niedrigmolekulare organische (= kohlenstoffhaltige) Verbindung, die über mindestens eine funktionelle Gruppe verfügt, die mit an der Oberfläche der Pulverteilchen vorhandenen Gruppen und der Polymermatrix reagieren und/oder (zumindest) wechselwirken kann, eignen sich insbesondere Verbindungen mit einem Molekulargewicht, das nicht höher als 500, vorzugsweise nicht höher als 350 und insbesondere nicht höher als 200 ist.
Derartige Verbindungen sind vorzugsweise unter Normalbedingungen flüssig und weisen vorzugsweise nicht mehr als insgesamt 15, insbesondere nicht mehr als insgesamt 10 und besonders bevorzugt nicht mehr als 8 Kohlenstoffatome auf. Die funktionellen Gruppen, die diese Verbindungen tragen müssen, richten sich in erster Linie nach den Oberflächengruppen des jeweils eingesetzten nanoskaligen Materials und darüber hinaus auch nach der gewünschten Wechselwirkung mit der Polymermatrix. So kann z.B. zwischen den funktionellen Gruppen der oberflächenmodifizierenden Verbindung und den Oberflächengruppen der Partikel eine Säure/Base-Reaktion nach Bronsted oder Lewis stattfinden (einschließlich Komplexbildung und Adduktbildung). Ein Beispiel für eine andere geeignete Wechselwirkung ist die Dipol-Dipol-Wechselwirkung. Beispiele für geeignete funktionelle Gruppen sind Carbonsäuregruppen, (primäre, sekundäre, tertiäre und quartäre) Aminogruppen und C-H-acide Gruppierungen (z.B. ß-Diketone). Es können auch mehrere dieser Gruppen gleichzeitig in einem Molekül vorhanden sein (Betaine, Aminosäuren, EDTA).

Demgemäss sind Beispiele für bevorzugte Oberflächenmodifikatoren gesättigte oder ungesättigte Mono- und Polycarbonsäuren (vorzugsweise Monocarbonsäuren) mit 1 bis 12 Kohlenstoffatomen (z.B. Ameisensäure, Essigsäure, Propionsäure, Buttersäure, Pentansäure, Hexansäure, Acrylsäure, Methacrylsäure, Crotonsäure, Citronensäure, Adipinsäure, Bernsteinsäure, Glutarsäure, Oxalsäure, Maleinsäure und Fumarsäure) sowie deren Ester (vorzugsweise C₁-C₄-Alkylester) und Amide, z.B. Methylmethacrylat.

Beispiele für weitere geeignete Oberflächenmodifikatoren sind Imide und quartäre Ammoniumsalze der Formel N⁺R¹⁰R²⁰R³⁰R⁴⁰Y⁻ worin R¹⁰ bis R⁴⁰ gegebenenfalls voneinander verschiedene aliphatische, aromatische oder cycloaliphatische Gruppen mit vorzugsweise 1 bis 12, insbesondere 1 bis 6 Kohlenstoffatomen darstellen und Y⁻ für ein anorganisches oder organisches Anion, z.B. Cl oder Acetat, steht; Mono- und Polyamine, insbesondere solche der allgemeinen Formel R₃₋ₙNHₙ, worin n = 0, 1 oder 2 und die Reste R unabhängig voneinander Alkylgruppen mit 1 bis 12, insbesondere 1 bis 6 und besonders bevorzugt 1 bis 4 Kohlenstoffatomen darstellen, z.B. Methyl, Ethyl, n- und i-Propyl und Butyl, und Ethylenpolyamine, z.B. Ethylendiamin, Diethylentriamin; Aminosäuren; Imine; ß-Dicarbonylverbindungen mit 4 bis 12, insbesondere 5 bis 8 Kohlenstoffatomen, wie z.B. Acetylaceton, 2,4-Hexandion, 3,5-Heptandion, Acetessigsäure und Acetessigsäure-C₁-C₄-alkylester; und modifizierte Alkoholate, bei denen ein Teil der OR-Gruppen (R wie oben definiert) durch inerte organische Gruppen substituiert ist.

Zur elektrostatischen Stabilisierung der nanoskaligen Teilchen können z.B. auch die für diesen Zweck bekannten Verbindungen, wie z.B. NaOH, NH₃, KOH, Al(OH)₃ oder Tetramethylammoniumhydroxid, eingesetzt werden.

Die erfindungsgemäß verwendeten Nanokomposit-Zusammensetzungen können weiterhin polymerisierbare monofunktionelle und/oder bifunktionelle organische Monomere, Oligomere und/oder Polymere aus der Gruppe der (Poly)Acrylsäure, (Poly)Methacrylsäure, (Poly)Acrylate, (Poly)Methacrylate, (Poly)Acrylamide, (Poly)Methacrylamide, (Poly)Carbamide, (Poly)Olefine, (Poly)Styrol, (Poly)Amide, (Poly)lmide, (Poly)Vinylverbindungen, (Poly)Ester, (Poly)Arylate, (Poly)Carbonate, (Poly)Ether, (Poly)Etherketone, (Poly)Sulfone, (Poly)Epoxide, Fluorpolymere, Organo(poly)siloxane, (Poly)Siloxane und Hetero(poly)siloxane enthalten. Beispiele sind (Poly)vinylchlorid, (Poly)vinylalkohol, (Poly)vinylbutyral, entsprechende Copolymere, z.B. Poly(ethylen-vinylacetat), Polyethylenterephthalat, Polyoxymethylen, Polyethylenoxid oder Polyphenylenoxid, Organopolysiloxane oder mit Metallen und Übergangsmetallen gebildete Heteropolysiloxane, wie sie z.B. in den EP-A-36 648 und EP-A-223 067 beschrieben sind, sowie Mischungen von zwei oder mehreren dieser Polymere, soweit sie miteinander verträglich sind. Anstelle der genannten Polymere können auch deren Oligomere und/oder Vorstufen (Monomere) eingesetzt werden. Unter diesen Polymeren sind in organischen Lösungsmitteln lösliche Polymere, wie Polyacrylate, Polymethacrylate (z.B. PMMA), Glycidylether, wie z.B. Bisphenol A-Diglycidether, und Polyvinylbutyral besonders bevorzugt.

Die polymerisierbaren monofunktionellen und/oder bifunktionellen organischen Monomere, Oligomere und/oder Polymere können in einer Menge von 0 bis 20 Mol-%, vorzugsweise 0,1 bis 15 Mol-%, insbesondere 1 bis 10 Mol-%, bezogen auf das polymerisierbare Silan, enthalten sein.

Eine bevorzugte Nanokomposit-Zusammensetzung enthält weiterhin ein Fluorsilan der Formel (III)

R³ (X¹)₃Si (III)

worin
R³ ein teil- oder perfluoriertes C₂-C₂₀-Alkyl ist, und
X¹ C₁-C₃-Alkoxy, Methyl, Ethyl oder Chlor bedeutet.

Unter teilfluoriertem Alkyl werden solche Alkylreste verstanden, in denen mindestens ein Wasseratom durch ein Fluoratom ersetzt ist.
Bevorzugte Reste R³ sind CF₃CH₂CH₂, C₂F₅CH₂CH₂, C₄F₉CH₂CH₂, n-C₆F,₃CH₂CH₂, n-C₈F₁₇CH₂CH₂, n-C₁₀F₂₁CH₂CH₂ und i-C₃F₇O-(CH₂)₃.

Beispiele für Fluorsilane der Formel (III), die auch im Handel erhältlich sind, sind Tridecafluoro-1,1,2,2-tetrahydrooctyl-1-triethoxysilan, CF₃CH₂CH₂ SiCl₂CH₃, CF₃CH₂CH₂ SiCl(CH₃)₂, CF₃CH₂CH₂Si(CH₃)(OCH₃)₂, i-C₃F₇O-(CH₂)₃SiCl₂ CH₃, n-C₆F₁₃ CH₂CH₂SiCl₂CH₃ und n-C₆F₁₃CH₂CH₂ SiCl(CH₃)₂.

Die Fluorsilane der Formel (III) können in einer Menge von 0 bis 3 Gew.-%, vorzugsweise 0,05 bis 3 Gew.-%, besonders bevorzugt 0,1 bis 2,5 Gew.-%, insbesondere 0,2 bis 2 Gew.-%, bezogen auf Gesamtgewicht der Nanokomposit-Zusammensetzung, enthalten sein. Die Gegenwart von Fluorsilanen ist insbesondere dann erforderlich, wenn als Transferprägestempel ein Glas- oder Kieselglasstempel verwendet wird.

Die Nanokomposit-Zusammensetzung enthält zweckmäßigerweise einen Polymerisations-, Polyadditions- und/oder Polykondensationskatalysator, der die Vernetzung und Härtung thermisch und/oder photochemisch induzieren kann (kollektiv als "Vernetzungsinitiator" bezeichnet).

Als Photoinitiatoren können z.B. die im Handel erhältlichen Starter eingesetzt werden. Beispiele hierfür sind Irgacure^{®} 184 (1-Hydroxycyclohexylphenylketon), Irgacure^{®} 500 (1-Hydroxycyclohexylphenylketon, Benzophenon) und andere von der Firma Ciba erhältliche Photoinitiatoren vom Irgacure^{®}-Typ; Darocur^{®} 1173, 1116, 1398, 1174 und 1020 (erhältlich von der Firma Merck), Benzophenon, 2-Chlorthioxanthon, 2-Methylthioxanthon, 2-Isopropylthioxanthon, Benzoin, 4,4'-Dimethoxy-benzoin, Benzoinethylether, Benzoinisopropylether, Benzyldimethylketal, 1,1,1-Trichloracetophenon, Diethoxyacetophenon und Dibenzosuberon.

Als thermische Initiatoren kommen u.a. organische Peroxide in Form von Diacylperoxiden, Peroxydicarbonaten, Alkylperestern, Dialkylperoxiden, Perketalen, Ketonperoxiden und Alkylhydroperoxiden in Frage. Konkrete Beispiele für derartige thermische Initiatoren sind Dibenzoylperoxid, tert.-Butylperbenzoat und Azobisisobutyronitril.

Der Vernetzungsinitiator wird, wenn eingesetzt, gewöhnlich in einer Menge von 0,1 bis 5, vorzugsweise 0,5 bis 3 Gew.-%, bezogen auf die Nanokomposit-Zusammensetzung, angewandt.

Gegenstand der Erfindung ist ferner eine mikrolithographische Anordnung enthaltend
a) eine mikrostrukturierte Schicht einer Nanokomposit-Zusammensetzung als Topcoat;
b) einen Bottomcoat bestehend aus einem aromatenhaltigen (Co)polymer enthaltend Novolake, Styrole, (Poly)hydroxystyrole und/oder (Meth)-Acrylate;
c) ein Substrat.

Das Substrat ist vorzugsweise ein zu strukturierendes Halbleitermaterial,
z.B. ein Siliciumwafer oder Indium-Zinnoxid-Schichten auf Glas.
Der darauf befindliche Bottomcoat sollte eine gute Haftfähigkeit sowohl zu dem Topcoat a) als auch zum Substrat aufweisen, und hat bevorzugt eine Schichtdicke von etwa 0,1 bis 20 µm.

Gegenstand der Erfindung ist ferner ein Verfahren zur Herstellung einer solchen mikrolithographischen Anordnung, umfassend die Schritte:
i) Herstellung eines ungehärteten Solfilms der vorstehend beschriebenen Nanokomposit-Zusammensetzung;
ii) Herstellung eines Zielsubstrats, bestehend aus Bottomcoat b) und Substrat c);
iii) Übertragung von Solfilm-Material aus i) mittels eines mikrostrukturierten Transferprägestempels auf den Bottomcoat b) in ii);
iv) Härtung des übertragenen Solfilm-Materials;
v) Abtrennung des Transferprägestempels unter Erhalt einer geprägten Mikrostruktur als Topcoat a).

Der ungehärtete Solfilm i) ist zweckmäßigerweise auf einer planaren Anordnung, bestehend aus einem Support, z.B. Glas, Kieselglas, Kunststoff oder Siliciumwafer, und/oder einem haftvermittelnden Film aufgebracht. Der haftvermittelnde Film enthält organische Polymere, die eine gute Benetzung zu dem Support und dem darauf abzuscheidenden Nanokomposit-Solfilm gewährleisten. Der haftvermittelnde Film kann beispielsweise aus einem aromatenhaltigen Polymer oder Copolymer, enthaltend Novolake, Styrole, (Poly)hydroxystyrole und/oder (Meth)Acrylate, bestehen. Der haftvermittelnde Film kann mit bekannten Verfahren, wie z.B. Spincoating, auf den Support aufgebracht werden.

Anschließend wird die erfindungsgemäße Nanokomposit-Zusammensetzung durch bekannte Verfahren, wie z.B. Spincoating Spraycoating oder Rollercoating, als Solfilm auf den haftvermittelnden Film aufgebracht, zweckmäßigerweise in einer Filmdicke von 0,5 bis 1 µm. Der Solfilm hat vorzugsweise eine Viskosität von 80 mPa s bis 2 Pa s, bevorzugt 100 mPa s bis 1 Pa s und besonders bevorzugt von 200 mPa s bis 600 mPa s.
Die Nanokomposit-Zusammensetzung kann entweder als solche oder vorzugsweise als Lösung in einem organischen Lösungsmittel aufgebracht werden. Beispiele für geeignete Lösungsmittel sind Alkohole wie Butanol, Ketone wie Aceton, Ester wie Ethylacetat, Ether wie Tetrahydrofuran und aliphatische, aromatische und halogenierte Kohlenwasserstoffe wie Hexan, Benzol, Toluol und Chloroform.

Die Nanokomposit-Zusammensetzung kann beispielsweise hergestellt werden, indem man die nanoskaligen Partikel in einem der vorstehend genannten Lösungsmittel und/oder einer der genannten polymerisierbaren Verbindungen dispergiert, z.B. unter Rühren oder mittels Ultraschall. Die erhaltene Dispersion wird dann mit den übrigen Bestandteilen der Nanokomposit-Zusammensetzung, gegebenenfalls unter Verdünnung mit einem Lösungsmittel, vermischt. Das zum Verdünnen verwendete Lösungsmittel ist entweder identisch mit dem für die Dispersion verwendeten Lösungsmittel oder damit mischbar.

Sofern das verwendete Lösungsmittel nicht schon während des Auftragens des Nanokomposit-Solfilms verdampft, ist es zweckmäßig, das Lösungsmittel nach dem Auftragen des Films durch geeignete Maßnahmen, wie z.B. Erwärmen, weitgehend zu entfernen, da sonst eine Übertragung des Solfilm-Materials mittels Transferprägestempel problematisch ist.

Die Herstellung des Zielsubstrats kann nach den gleichen Methoden erfolgen. Der Bottomcoat kann die gleiche oder eine ähnliche Zusammensetzung haben wie der vorstehend beschriebene haftvermittelnde Film des Ausgangssubstrats.

Nach der Auftragung des Nanokomposit-Sols und Ablüften des Lösungsmittels sind die Fluorsilan-Moleküle an der Oberfläche angereichert, in die nun der Transferprägestempel aus Glas oder Kieselglas für etwa 5 bis 300 Sekunden, vorzugsweise 10 bis 60 Sekunden, eingedrückt wird (Immersionszeit).
Der Transferprägestempel kann auch aus Silikonkautschuk bestehen. In diesem Fall sind keine Fluorsilane der Formel (III) erforderlich.
Die fluorierten Seitenketten der Fluorsilan-Moleküle werden von der hydrophilen Oberfläche des Glas- oder Kieselglasstempels prinzipiell abgestoßen, von der Oberfläche des haftvermittelnden Films oder des Substrats nur schwach angezogen und diffundieren daher im Konzentrationsgradienten. Nach besagter Immersionszeit wird der Transferprägestempel aus dem überschüssigen Nanokomposit-Solfilm herausgezogen. Die Haftung des Solfilmmaterials ist in den 30 bis 500 nm, bevorzugt 100 bis 200 nm, tiefen und breiten Mikrokanälen des Stempels durch Kapillarkräfte und durch partielle Entfernung der Fluorsilanmoleküle von der (Kiesel)glasoberfläche hinreichend groß, so dass es vom Stempel mitgenommen wird. Bei Unterschreitung der Immersionszeit ist die Übertragung unvollständig.
Die Übertragung der Mikrostruktur auf das Zielsubstrat erfolgt durch die Luft vorzugsweise innerhalb von 10 bis 300 Sekunden. Dabei reichert sich das Fluorsilan an der Grenzfläche zur Luft an, so dass die Benetzung des Stempels sehr gut ist und das Sol sich im Transferstempel nicht zu einem Tropfen zusammenzieht.

Nach dem Aufsetzen des Transferstempels auf dem Bottomcoat b) des Zielsubstrats wird der Stempel über eine Dauer von 10 bis zweckmäßig 300 Sekunden, bevorzugt 20 bis 50 Sekunden, insbesondere 30 bis 40 Sekunden, mit einem Druck von 10 bis 100 kPa gegen den Bottomcoat b) gedrückt. Dabei diffundiert das Fluorsilan wieder in Richtung der (Kiesel)glasoberfläche, so dass nach der Härtung die Haftung zum Bottomcoat hinreichend gut und zum Transferstempel hinreichend schlecht ist. Die Schichtdicke des übertragenen Materials ist 50 bis 1000 nm, vorzugsweise 150 bis 500 nm.
Würde man das gleiche Nanokomposit-Sol ohne Fluorsilan verwenden und mit einem Kieselglasstempel übertragen, so wird auf dem Zielsubstrat keine Struktur abgeschieden. Das Sol verbleibt vollständig im Stempel.
Während der Transferprägestempel auf dem Bottomcoat aufliegt, erfolgt eine thermische Härtung oder eine UV-Härtung. Bei UV-transparenten Transferstempeln ist eine Härtung durch UV-Strahlung bevorzugt. Nach etwa 1 bis 10 minütiger Erwärmung auf etwa 80 bis 150°C, und/oder etwa 5 bis 20 minütiger UV-Bestrahlung ist das übertragene Solfilm-Material ausgehärtet und der Transferprägestempel wird unter Erhalt einer geprägten Mikrostruktur (Topcoat a) entfernt. Eine Untersuchung dieser mikrostrukturierten Anordnung mit Hilfe eines Rasterelektronenmikroskops zeigt, dass nicht nur die geprägte Mikrostruktur auf dem Zielsubstrat zurückbleibt, sondern auch eine unstrukturierte Restschicht des Nanokomposit-Solfilms von weniger als 30 nm Dicke.
Für eine spätere Anwendung in der Mikroelektronik ist es zur Erzielung einer hohen Kantensteilheit und eines hohen Aspektverhältnisses (Verhältnis von Höhe der Stege zu Abstand zwischen zwei Stegen) erforderlich, dass der Nanokomposit-Solfilm und der Bottomcoat eine unterschiedliche Ätzresistenz aufweisen.
So ist die erfindungsgemäß verwendete Nanokomposit-Zusammensetzung mit einem CHF₃/O₂-Gasgemisch ätzbar, nicht aber durch ein Sauerstoffplasma. Bei dem Bottomcoat ist es umgekehrt.

Die vorliegende Erfindung umfasst daher auch ein Verfahren zur Herstellung eines mikrostrukturierten Halbleitermaterials, umfassend die vorstehend genannten Schritte i) bis v), wobei Support c) das zu strukturierende Halbleitermaterial darstellt, sowie die Schritte
vi) Plasmaätzung der Restschicht des Nanokomposit-Solfilms, vorzugsweise mit CHF₃/O₂-Plasma,
vii) Plasmaätzung des Bottomcoat, vorzugsweise mit O₂-Plasma,
viii) Dotierung des Halbleitermaterials an den geätzten Stellen, oder Ätzung des Halbleitermaterials.

Nach dem Ätzprozess lässt sich die Resist-Beschichtung mit herkömmlichen Lösemitteln, wie z.B. Tetramethylammoniumhydroxid, entfernen.

Rasterelektronenmikroskopische Aufnahmen zeigen, dass nach dem erfindungsgemäßen Verfahren Nanostrukturen mit einer Kantenlänge von ca. 150 nm und einer Kantensteilheit von ca. 90° geprägt werden.

### Beispiele

### 1) Herstellung einer Nanokomposit-Zusammensetzung

236,1 g (1 mol) Glycidyloxypropyltrimethoxysilan (GPTS) werden mit 27 g (1,5 mol) Wasser 24 Stunden am Rückfluss gekocht. Anschließend wird entstandenes Methanol am Rotationsverdampfer bei 70°C abgezogen.

Zu dem so hergestellten GPTS-Kondensat werden unter Rühren 345 g Tetrahexylammoniumhydroxid-modifiziertes Kieselsol (SiO₂-Kolloid, Durchmesser ca. 10 nm, ca. 30 gew.-%ig in Isopropanol, modifiziert mit 2,4 mg Tetrahexylammoniumhydroxid-Lösung (40 gew.-%ig in Wasser) pro g Kieselsol) gegeben. Anschließend wird das Isopropanol am Rotationsverdampfer entfernt. Zum lösemittelfreien Sol werden jeweils 1 Gew.-%, bezogen auf das Sol, eines kationischen Photostarters (UVI 6974, Union Carbide) und Tridecafluoro-1,1,2,2-tetrahydrooctyl-1-triethoxysilan, sowie 22,3 g (0,0714 mol) Bisphenol-A-Diglycidether gegeben.
Das Sol wird durch Zugabe von Isopropoxyethanol verdünnt, bis man eine Nanokomposit-Zusammensetzung mit einer Viskosität von etwa 300 mPa s erhält.

### 2) Herstellung des Novolaks für Ausgangssubstrat und Zielsubstrat:

120 g m-Kresol, 60 g p-Kresol und 106,8 g 37 gew.%-iges Formalin werden zusammen mit 4 g Oxalsäuredihydrat für 6 Stunden bei 100°C erhitzt. Zur destillativen Entfernung von Wasser und nichtumgesetztem Kresol, Formaldehyd und Oxalsäure wird die Reaktionsmischung auf 200°C erwärmt, und der Druck auf 50 mbar reduziert. Man erhält 172 g Novolak als Feststoff.

### 3) Herstellung des Ausgangssubstrats:

a) Ein mit Hexamethyldisilazan vorbehandelter 4-Zoll-Siliciumwafer wird in einem Spincoater mit einer Novolak-Lösung (17,5 g des oben hergestellten Novolaks in 82,3 g PGMEA) beschichtet. Anschließend erfolgt ein Softbake für 90 s bei 110°C und ein Hardbake für 90 s bei 235°C, so dass die resultierende Schichtdicke etwa 500 nm beträgt (haftvermitteinde Schicht).
b) Auf die so hergestellte haftvermitteinde Schicht wird die oben hergestellte Nanokomposit-Zusammensetzung durch Spincoating (2000 Umdrehungen, 30 s) aufgetragen. Der Solfilm wird zur Entfernung des Lösungsmittels für 1 Minute bei etwa 25°C getrocknet, ohne dass der Solfilm aushärtet.
   Die Schichtdicke des Nanokomposit-Solfilms beträgt etwa 500 nm.

### 4) Herstellung des Zielsubstrats:

Die Herstellung des Zielsubstrats erfolgt analog zu 3a).

### 5) Übertragung und Prägen der Mikrostruktur auf das Zielsubstrat:

Die Prägeapparatur ist eine rechnergesteuerte Prüfmaschine (Modell Zwick 1446), die es ermöglicht, Be- und Entlastungsgeschwindigkeiten zu programmieren und definierte Drücke über eine bestimmte Zeit zu halten. Die Kraftübertragung erfolgt über eine Welle, an der der Prägestempel über ein Gelenk befestigt ist. Dies ermöglicht eine exakte Ausrichtung der Prägestruktur zum Substrat. Zur photochemisch initiierten Aushärtung dient ein Metallhalogenidstrahler (Modell UV-S400 der Fa. Panacol-Elosol GmbH, UV-A-Strahlung 325-380 nm).

In die nichtausgehärtete Solfilmschicht des oben hergestellten Ausgangssubstrats wird ein mikrostrukturierter Kieselglasstempel (4 x 4 cm, Strukturtiefe 200 nm) mit einer Kraft von 40 N eingedrückt. Nach einer Wartezeit von 15 s wird der Stempel aus dem überschüssigen Solfilm herausgezogen. Der nun vollständig mit Solfilmmaterial benetzte Stempel wird 30 s lang an der Luft gehalten, dann auf das oben hergestellte Zielsubstrat aufgesetzt und für 35 s mit einer Kraft von 50 N auf den Bottomcoat gedrückt, wobei der übertragene Film mit dem UV-Strahler gehärtet wird. Nach einer Präge- und Belichtungszeit von insgesamt 5 Minuten wird der Stempel entfernt und das gehärtete mikrostrukturierte Solfilmmaterial auf dem Zielsubstrat zurückbehalten.
Eine rasterelektronenmikroskopische Aufnahme der Beschichtung zeigt, dass Strukturen mit einer Geometrie von 150 nm x 150 nm mit hoher Kantensteilheit wiedergegeben werden. Zwischen Bottomcoat und den übertragenen Strukturen ist eine Restschichtdicke von 25 nm Solfilmmaterial vorhanden.

### 6) Ätzprozess

Das Substrat wurde unter folgenden Bedingungen geätzt:
1) Mit CHF₃/O₂ (25:10), 300 W, 50 mTorr, RIE-Modus, anisotrop; zur Entfernung der Rest-Topcoat-Schicht;
2) mit O₂, 300 W, 50 mTorr, RIE-Modus, anisotrop; zur Entfernung des Bottomcoat.

Aspektverhältnis ca. 3.

## Patentansprüche

1. Mikrolithographische Anordnung enthaltend
a) eine mikrostrukturierte Schicht einer Nanokomposit-Zusammensetzung enthaltend
a1) ein polymerisierbares Silan der allgemeinen Formel (I) und/oder (II) und/oder davon abgeleitete Kondensate
SiX₄ (I)
in der die Reste X gleich oder verschieden sind und hydrolysierbare Gruppen oder Hydroxylgruppen bedeuten;
R¹ₐR²_{b}SiX(_{4-a-b}) (II)
worin R¹ ein nicht hydrolysierbarer Rest ist, R² einen eine funktionelle Gruppe tragenden Rest bedeutet, X die vorstehende Bedeutung hat und a und b den Wert 0, 1, 2 oder 3 aufweisen, wobei die Summe (a + b) den Wert 1, 2 oder 3 aufweist, sowie
a2) nanoskalige Teilchen aus der Gruppe der Oxide, Sulfide, Selenide, Telluride, Halogenide, Carbide, Arsenide, Antimonide, Nitride, Phosphide, Carbonate, Carboxylate, Phosphate, Sulfate, Silikate, Titanate, Zirkonate, Aluminate, Stannate, Plumbate sowie Mischoxide davon, als Topcoat;
b) einen Bottomcoat bestehend aus einem aromatenhaltigen Polymer oder Copolymer enthaltend Novolake, Styrole, (Poly)hydroxystyrole und/oder (Meth)Acrylate;
c) ein Substrat.

2. Mikrolithographische Anordnung nach Anspruch 1, **dadurch gekennzeichnet, dass** der Topcoat a) ein Solfilm ist.

3. Mikrolithographische Anordnung nach Anspruch 1 oder 2, **dadurch gekennzeichnet, dass** das Substrat c) ein Halbleitermaterial ist.

4. Mikrolithographische Anordnung nach mindestens einem der Ansprüche 1 bis 3, **dadurch gekennzeichnet, dass** die Nanokomposit-Zusammensetzung 1 bis 50 Volumenprozent, vorzugsweise 1 bis 30 Volumenprozent, nanoskalige Teilchen enthält.

5. Mikrolithographische Anordnung nach mindestens einem der Ansprüche 1 bis 4, **dadurch gekennzeichnet, dass** die nanoskaligen Teilchen mit Verbindungen aus der Gruppe der Carbonsäuren, Carbonsäureamide, Carbonsäureester, Aminosäuren, ß-Diketone, Imide, quartären Ammoniumsalzen der allgemeinen Formel N⁺R¹⁰R²⁰R³⁰R⁴⁰Y⁻ wobei die Reste R¹⁰ bis R⁴⁰, gleich oder verschieden sind und aliphatische, aromatische und/oder cycloaliphatische Gruppen sein können und Y⁻ ein anorganisches oder organisches Anion darstellen, oberflächenmodifiziert sind.

6. Mikrolithographische Anordnung nach mindestens einem der Ansprüche 1 bis 5, **dadurch gekennzeichnet, dass** die Nanokomposit-Zusammensetzung polymerisierbare monofunktionelle und/oder bifunktionelle Monomere, Oligomere und/oder Polymere aus der Gruppe der (Poly)Acrylsäure, (Poly)Methacrylsäure, (Poly)Acrylate, (Poly)Methacrylate, (Poly)Acrylamide, (Poly)Methacrylamide, (Poly)Carbamide, (Poly)Olefine, (Poly)Styrol, (Poly)Amide; (Poly)imide, (Poly)Vinylverbindungen, (Poly)Ester, (Poly)Arylate, (Poly)Carbonate, (Poly)Ether, (Poly)Etherketone, (Poly)Sulfone, (Poly)Epoxide, Fluorpolymere, Organo(poly)siloxane, (Poly)Siloxane und Hetero(poly)siloxane enthält.

7. Mikrolithographische Anordnung nach mindestens einem der Ansprüche 1 bis 6, **dadurch gekennzeichnet, dass** die Nanokomposit-Zusammensetzung ein Fluorsilan der Formel (III) enthält
R³ (X¹)₃Si (III)
worin
R³ ein teil oder perfluoriertes C₂-C₂₀-Alkyl ist und
X¹ C₁-C₃-Alkoxy, Chlor, Methyl oder Ethyl bedeuten.

8. Mikrolithographische Anordnung nach mindestens einem der Ansprüche 1 bis 7, **dadurch gekennzeichnet, dass** die Nanokomposit-Zusammensetzung einen Vernetzungsinitiator enthält.

9. Verfahren zur Herstellung einer mikrolithographischen Anordnung nach einem oder mehreren der Ansprüche 1 bis 8, umfassend die Schritte:
i) Herstellung eines planaren ungehärteten Solfilms der besagten Nanokomposit-Zusammensetzung;
ii) Herstellung eines Zielsubstrats, bestehend aus einem Bottomcoat b) und einem Support c);
iii) Übertragung von Solfilm-Material aus i) mittels eines mikrostrukturierten Transferprägestempels auf den Bottomcoat b) in ii);
iv) Härtung des übertragenen Solfilm-Materials;
v) Abtrennung des Transferprägestempels unter Erhalt einer geprägten Mikrostruktur als Topcoat a).

10. Verfahren nach Anspruch 9, **dadurch gekennzeichnet, dass** der ungehärtete Solfilm i) auf einem planaren Ausgangssubstrat, bestehend aus einem Support und/oder einem haftvermittelnden Film, aufgebracht ist.

11. Verfahren nach Anspruch 9 oder 10, **dadurch gekennzeichnet, dass** der Transferprägestempel aus Silikon, Glas oder Kieselglas besteht.

12. Verfahren nach einem oder mehreren der Ansprüche 9 bis 11, **dadurch gekennzeichnet, dass** der Transferprägestempel für 5 bis 300 Sekunden in den Solfilm i) hineingedrückt, dann herausgezogen und innerhalb von 10 bis 300 Sekunden auf dem Bottomcoat b) aufgesetzt wird und über eine Dauer von 10 bis 300 Sekunden mit einem Druck von 10 bis 100 kPa gegen b) gedrückt wird.

13. Verfahren nach einem oder mehreren der Ansprüche 9 bis 12, **dadurch gekennzeichnet, dass** eine thermische Härtung oder eine UV-Härtung durchgeführt wird, während der Transferprägestempel gegen b) gedrückt ist.

14. Verfahren zur Herstellung eines mikrostrukturierten Halbleitermaterials, umfassend die Schritte i) bis v) nach Anspruch 9, wobei Support c) das zu strukturierende Halbleitermaterial darstellt, sowie die Schritte
vi) Plasmaätzung der Restschicht des Nanokomposit-Solfilms, vorzugsweise mit CHF₃/O₂-Plasma,
vii ) Plasmaätzung des Bottomcoat, vorzugsweise mit O₂-Plasma,
viii) Ätzung des Halbleitermaterials oder Dotierung des Halbleitermaterials an den geätzten Stellen.

## Claims

1. A microlithographic arrangement comprising
a) a microstructured layer of a nanocomposite composition as a top coat, comprising
a1) a polymerizable silane of the general formula (I) and/or (II) and/or condensates derived therefrom
SiX₄ (I)
in which the radicals X are identical or different and are hydrolysable groups or hydroxyl groups;
R¹ₐR²_{b}SiX(_{4-a-b}) (II)
in which R¹ is a nonhydrolyzable radical, R² is a radical carrying a functional group, X has the above meaning and a and b have the value 0, 1, 2 or 3, the sum (a+b) having the value 1, 2 or 3, and
a2) nanoscale particles selected from the group consisting of the oxides, sulfides, selenides, tellurides, halides, carbides, arsenides, antimonides, nitrides, phosphides, carbonates, carboxylates, phosphates, sulfates, silicates, titanates, zirconates, aluminates, stannates, plumbates and mixed oxides thereof;
b) a bottom coat comprising an aromatics-containing polymer or copolymer containing novolaks, styrenes, (poly)hydroxystyrenes and/or (meth)acrylates;
c) a substrate.

2. The microlithographic arrangement as claimed in claim 1, **characterized in that** the top coat a) is a sol film.

3. The microlithographic arrangement as claimed in claim 1 or 2, **characterized in that** the substrate c) is a semiconductor material.

4. The microlithographic arrangement as claimed in at least one of claims 1 to 3, **characterized in that** the nanocomposite composition contains from 1 to 50 percent by volume, preferably from 1 to 30 percent by colume, of nanoscale particles.

5. The microlithographic arrangement as claimed in at least one of claims 1 to 4, **characterized in that** the nanoscale particles have been surface-modified with compounds selected from the group consisting of the carboxylic acids, carboxamides, carboxylic esters, amino acids, β-diketones, imides, quaternary ammonium salts of the general formula N⁺R¹⁰R²⁰R³⁰R⁴⁰Y⁻, where the radicals R¹⁰ to R⁴⁰ are identical or different and may be aliphatic, aromatic and/or cycloaliphatic groups and Y⁻ is an inorganic or organic anion.

6. The microlithographic arrangement as claimed in at least one of claims 1 to 5, **characterized in that** the nanocomposite composition contains polymerizable monofunctional and/or bifunctional monomers, oligomers and/or polymers selected from the group consisting of (poly)acrylic acid, (poly)methacrylic acid, (poly)acrylates, (poly)methacrylates, (poly)acrylamides, (poly)methacrylamides, (poly)carbamides, (poly)olefins, (poly)styrene, (poly)amides, (poly)imides, (poly)vinyl compounds, (poly)esters, (poly)arylates, (poly)carbonates, (poly)ethers, (poly)etherketones, (poly)sulfones, (poly)epoxides, fluorine polymers, organo(poly)siloxanes, (poly)siloxanes and hetero(poly)siloxanes.

7. The microlithographic arrangement as claimed in at least one of claims 1 to 6, **characterized in that** the nanocomposite composition contains a fluorosilane of the formula (III)
R³(X¹)₃Si (III)
in which
R³ is a partly fluorinated or perfluorinated C₂-C₂₀-alkyl and
X¹ is C₁-C₃-alkoxy, chlorine, methyl or ethyl.

8. The microlithographic arrangement as claimed in at least one of claims 1 to 7, **characterized in that** the nanocomposite composition contains a crosslinking initiator.

9. A method for the production of a microlithographic arrangement as claimed in one or more of claims 1 to 8, comprising the steps:
i) production of a planar uncured sol film of the said nanocomposite composition;
ii) production of a target substrate comprising a bottom coat b) and a support c);
iii) transfer of sol film material from i) by means of a microstructured transfer imprint stamp to the bottom coat b) in ii);
iv) curing of the transferred sol film material;
v) removal of the transfer imprint stamp to give an imprinted microstructure as top coat a).

10. The method as claimed in claim 9, **characterized in that** the uncured sol film i) is applied to a planar starting substrate comprising a support and/or an adhesion-promoting film.

11. The method as claimed in claim 9 or 10, **characterized in that** the transfer imprint stamp comprises silicone, glass or silica glass.

12. The method as claimed in one or more of claims 9 to 11, **characterized in that** the transfer imprint stamp is pressed into the sol film i) for from 5 to 300 seconds, then removed and placed on the bottom coat b) in the course of from 10 to 300 seconds and pressed against b) for a time of from 10 to 300 seconds under a pressure of from 10 to 100 kPa.

13. The method as claimed in one or more of claims 9 to 12, **characterized in that** thermal curing or UV curing is carried out while the transfer imprint stamp is pressed against b).

14. A method for the production of a microstructured semiconductor material, comprising the steps i) to v) as claimed in claim 9, support c) being the semiconductor material to be structured, and the steps
vi) plasma etching of the residual layer of the nanocomposite sol film, preferably with CHF₃/O₂ plasma,
vii) plasma etching of the bottom coat, preferably with O₂ plasma,
viii) etching of the semiconductor material or doping of the semiconductor material in the etched areas.

## Revendications

1. Agencement de microlithographie contenant :
a) une couche microstructurée d'une composition de nanocomposite, contenant :
a1) un silane polymérisable de la formule générale (I) et/ou (II) et/ou des condensats dérivés de celui-ci
SiX₄ (I)
dans laquelle les restes X sont identiques ou différents et représentent des groupes hydrolysables ou des groupes hydroxyle ;
R¹ₐR²_{b}SiX_{(4-a-b)} (II)
dans laquelle R¹ est un reste non hydrolysable, R² représente un reste portant un groupe fonctionnel, X a la signification ci-dessus, et a et b présentent la valeur 0, 1, 2 ou 3, où la somme (a + b) présente la valeur 1, 2 ou 3, ainsi que
a2) des particules nanométriques choisies dans le groupe formé par les oxydes, sulfures, séléniures, tellurures, halogénures, carbures, arséniures, antimoniures, nitrures, phosphures, carbonates, carboxylates, phosphates, sulfates, silicates, titanates, zirconates, aluminates, stannates, plombates, ainsi que des oxydes mixtes de ceux-ci, comme couche de couverture :
b) une couche de fond consistant en un polymère ou copolymère à groupes aromatiques, contenant des novolaques, des styrènes, des (poly)hydroxystyrènes et/ou des (méth)acrylates ;
c) un substrat.

2. Agencement de microlithographie selon la revendication 1, **caractérisé en ce que** la couche de couverture a) est un film de sol.

3. Agencement de microlithographie selon la revendication 1 ou 2, **caractérisé en ce que** le substrat c) est un matériau semi-conducteur.

4. Agencement de microlithographie selon au moins l'une des revendications 1 à 3, **caractérisé en ce que** la composition de nanocomposite contient 1 à 50 % en volume, de préférence 1 à 30 % en volume de particules nanométriques.

5. Agencement de microlithographie selon au moins l'une des revendications 1 à 4, **caractérisé en ce que** les particules nanocomposites sont modifiées en surface avec des composés choisis dans le groupe formé par les acides carboxyliques, les amides d'acides carboxyliques, les esters d'acides carboxyliques, les acides aminés, les β-dicétones, les imides, les sels d'ammonium quaternaire de formule générale N⁺R¹⁰R²⁰R³⁰R⁴⁰Y⁻, où les restes R¹⁰ à R⁴⁰ sont identiques ou différents et peuvent être des groupes aliphatiques, aromatiques et/ou cycloaliphatiques, et Y⁻ représente un anion minéral ou organique.

6. Agencement de microlithographie selon au moins l'une des revendications 1 à 5, **caractérisé en ce que** la composition de nanocomposite contient des monomères, oligomères et/ou polymères polymérisables, monofonctionnels et/ou bifonctionnels, choisis dans le groupe formé par les (poly)acides acryliques, (poly)acides méthacryliques, (poly)acrylates, (poly)méthacrylates, (poly)acrylamides, (poly)méthacrylamides, (poly)carbamides, (poly)oléfines, (poly)styrènes, (poly)amides, (poly)imides, (poly)composés vinyliques, (poly)esters, (poly)arylates, (poly)carbonates, (poly)éthers, (poly)éthercétones, (poly)sulfones, (poly)époxydes, fluoropolymères, organo(poly)siloxanes, (poly)siloxanes et hétéro(poly)siloxanes.

7. Agencement de microlithographie selon au moins l'une des revendications 1 à 6, **caractérisé en ce que** la composition de nanocomposite contient un fluorosilane de formule (III)
R³(X¹)Si (III)
dans laquelle
R³ est un alkyle en C₂-C₂₀ partiellement fluoré ou perfluoré,
X¹ représente alcoxy en C₁-C₃, chlore, méthyle ou éthyle.

8. Agencement de microlithographie selon au moins l'une des revendications 1 à 7, **caractérisé en ce que** la composition de nanocomposite contient un amorceur de réticulation.

9. Procédé de préparation d'un agencement de microlithographie selon l'une ou plusieurs des revendications 1 à 8, comprenant les étapes de :
i) préparation d'un film de sol non durci, plan, de ladite composition de nanocomposite ;
ii) préparation d'un substrat cible, constitué d'une couche de fond b) et d'un support c) ;
iii) transfert du matériau du film de sol de i) à l'aide d'un tampon de transfert microstructuré sur la couche de fond b) de ii) ;
iv) durcissement de matériau du film de sol transféré ;
v) séparation du tampon de transfert avec maintient d'une microstructure imprimée comme couche de couverture a).

10. Procédé selon la revendication 9, **caractérisé en ce que** le film de sol non durci i) est appliqué sur un substrat de départ plan, constitué d'un support et/ou d'un film auxiliaire d'adhérence.

11. Procédé selon la revendication 9 ou 10, **caractérisé en ce que** la matrice de transfert est en silicone, en verre ou en verre de silice.

12. Procédé selon l'une ou plusieurs des revendications 9 à 11, **caractérisé en ce que** le tampon de transfert est pressé pendant 5 à 300 secondes dans le film de sol i), retiré, appliqué sur la couche de fond b) dans les 10 à 300 secondes et pressé pendant une durée de 10 à 300 secondes avec une pression de 10 à 100 kPa, contre b).

13. Procédé selon l'une ou plusieurs des revendications 9 à 12, **caractérisé en ce qu'**un durcissement thermique ou un durcissement par U.V. est réalisé, pendant que le tampon de transfert est pressé sur b).

14. Procédé de préparation d'un matériau semi-conducteur microstructué, comprenant les étapes i) à v) de la revendication 9, où le support c) est le matériau semi-conducteur à microstructurer, ainsi que les étapes suivantes :
vi) attaque par plasma de la couche résiduelle du film de sol de nanocomposite, de préférence avec un plasma CHF₃/O₂,
vii) attaque par plasma de la couche de fond, de préférence avec un plasma O₂,
viii) attaque du matériau semi-conducteur ou dopage du matériau semi-conducteur au niveau des sites attaqués.
